# EUROPÄISCHE PATENTSCHRIFT

(11) **EP 3 168 858 B1**
(45) Veröffentlichungstag und Bekanntmachung des Hinweises auf die Patenterteilung: **16.06.2021**
(21) Anmeldenummer: 16197904.2
(22) Anmeldetag: 09.11.2016
(51) Int. Cl.: H01J 37/32, H05H 1/24

(54) **VORRICHTUNG, SYSTEM UND VERFAHREN ZUR BEHANDLUNG EINES GEGENSTANDES MIT PLASMA**
DEVICE, SYSTEM AND METHOD FOR TREATING AN OBJECT WITH PLASMA
DISPOSITIF, SYSTÈME ET PROCÉDÉ DE TRAITEMENT D'UN OBJET AU PLASMA

(30) Priorität: 10.11.2015 DE 102015119369
(43) Veröffentlichungstag der Anmeldung: 17.05.2017
(73) Patentinhaber: Leibniz-Institut für Plasmaforschung und Technologie e.V., 17489 Greifswald (DE)
(72) Erfinder: Ehlbeck, Dr. Jörg, 17498 Hinrichshagen (DE); Stieber, Dr. Manfred, 17489 Greifswald (DE); Stachowiak, Jörg, 17489 Greifswald (DE)
(74) Vertreter: Schulz Junghans Patentanwälte PartGmbB

(56) Entgegenhaltungen:
- WO-A2-2009/019156
- DE-A1-102004 049 783
- DE-A1-102010 003 284
- DE-A1-102013 107 448
- DE-U1-202008 008 734
- US-A1- 2012 213 664
- US-B2- 8 961 894

## Beschreibung

Die vorliegende Erfindung betrifft eine Vorrichtung sowie ein System und ein Verfahren zur Behandlung eines Gegenstandes, insbesondere eines oder mehrerer Freiformkörper, mit Plasma. Der zu behandelnde Gegenstand kann insbesondere ein Roh-Lebensmittel, wie z. B. ein Ei, oder auch ein Obst oder ein Gemüse sein, oder auch eine Verpackung bzw. eine Verschlusskappe oder ähnliches. Die Behandlung des Gegenstandes mit Plasma dient vorzugsweise dem Ziel der Dekontamination und Sterilisation der Oberfläche des Gegenstandes.

Insbesondere in der lebensmittelverarbeitenden Industrie besteht ein hoher Bedarf an Dekontaminationsverfahren für "Freiformkörperwie z.B. Gemüse, Obst und Konsumeiern. Es besteht ein zunehmender Wunsch, die klassischen chemischen Verfahren - obwohl als sehr sichere Verfahren bewährt - durch alternative Methoden abzulösen. Dabei sollen höhere Keimreduktionraten bei gleichbleibender Erhaltung der wesentlichen Eigenschaften und Beschaffenheit von rohen und verarbeiteten Lebensmitteln realisiert werden. Verfahren der Gassterilisation, wie z.B. die Verwendung von Formaldehyd oder Wasserstoffperoxid in der Eiproduktion, sind problematisch in der Applikation und steigern das Risiko der Karzinogenität bei Bruteiern.

Plasmabasierte indirekte Verfahren, wie z.B. Ozonisierung, sind hinsichtlich der auftretenden Geruchs- und Geschmacksbeeinträchtigungen zumindest im Lebensmittelbereich ungeeignet.

Niederdruckreaktoren verursachen durch aufwändige und insbesondere bei Batchbetrieb große Behältnisse mit hohen Totvolumina hohe Investitionskosten. Die bei hohen Durchsatz-Raten erforderlichen Pumpraten sind ein weiterer Kostenfaktor für Investition und Betrieb.

In der WO 2009/019156 A2 sind ein Verfahren und mehrere Vorrichtungen zur plasmagestützten trockenen Reinigung, Aktivierung, Beschichtung, Modifizierung und biologischer Dekontamination von Oberflächen mittels eines unter dielektrisch behinderter Entladung erzeugtem Atmosphärendruckplasmas beschrieben.

Ferner offenbart US 2012/0213664 A1 eine Vorrichtung zur Behandlung eines Gegenstandes mit Plasma, umfassend eine erste Elektrode sowie eine zweite Elektrode und eine Hülleinrichtung, mit der ein Aufnahmeraum ausgebildet ist, in dem ein zu behandelnder Gegenstand aufnehmbar ist, wobei die Hülleinrichtung gegen die zweite Elektrode gedrückt wird.

Aus DE 10 2010 003 284 A1 ist eine Vorrichtung zur Behandlung eines Gegenstandes mit Plasma bekannt, wobei ein dielektrisches Begrenzungsmaterial eines abgeschlossenen Volumens mittels Vakuum unmittelbar an die Elektroden angesaugt wird.

Als weitere Einrichtung zur Dekontamination von Oberflächen sind sogenannte "Plasmapatches" bzw. "Plasmapflaster" bekannt, die überwiegende Anwendung zu medizinischen Zwecken finden.

Die auf eine Plasmamanschette gerichtete internationale Patentanmeldung WO 2011/023478 A1 offenbart eine Einrichtung, in der eine dielektrisch behinderte Oberflächenentladung durch eine flexibles Dielektrikum, eine flexible geerdete erste Elektrode und eine flexible zweite Hochspannungselektrode erzeugt wird. Die Hochspannungselektrode ist in das Dielektrikum eingebettet. Aufgrund der Flexibilität des Dielektrikums sowie der Elektroden erhält die gesamte Plasmamanschette einen leicht verformbaren Aufbau, der dementsprechend leicht an Körperkonturen anpassbar ist. Beim Prozess der Anpassung der Manschette an die Körperkontur und der dadurch bedingten Verformung ist die Manschette jedoch ständig einer schwellenden oder wechselnden Belastung unterworfen, sodass es während mehrerer Behandlungszyklen zu einer Instabilität der Einbettung der Elektrode in das Dielektrikum kommen kann, woraus eine Delamination der Elektrode vom Dielektrikum und eine dadurch bedingte geringere Lebensdauer und demzufolge eine begrenzte Zyklenzahl der Anwendung der Plasmamanschette resultieren kann.

Der vorliegenden Erfindung liegt die Aufgabe zugrunde, eine Vorrichtung, ein System und Verfahren zur Behandlung eines Gegenstandes mit Plasma zur Verfügung zu stellen, mit denen in einfacher, zuverlässiger und kostengünstiger Weise über eine lange Lebensdauer der genutzten Einrichtungen eine schonende Plasmabehandlung von Gegenständen, insbesondere von dreidimensionalen Freiformkörpern realisierbar ist.

Dieser Aufgabe wird durch die erfindungsgemäße Vorrichtung zur Behandlung eines Gegenstandes mit Plasma nach Anspruch 1 sowie durch das erfindungsgemäße System zur Behandlung mehrerer Gegenstände mit Plasma nach Anspruch 10 und durch das Verfahren zur Behandlung eines Gegenstandes mit Plasma nach Anspruch 11 gelöst. Vorteilhafte Ausgestaltungen der erfindungsgemäßen Vorrichtung sind in den Unteransprüchen 2 - 9 angegeben. Vorteilhafte Ausgestaltungen des erfindungsgemäßen Verfahrens sind in den Unteransprüchen 12 - 14 angegeben. Die erfindungsgemäße Vorrichtung ist zur Behandlung eines Gegenstandes mit Plasma ausgestaltet und umfasst eine Hülleinrichtung, mit der ein im Wesentlichen gasdichter Aufnahmeraum ausgebildet oder ausbildbar ist, in dem ein zu behandelnder Gegenstand aufnehmbar ist. Weiterhin umfasst die Vorrichtung eine erste Elektrode sowie eine zweite Elektrode, wobei die beiden Elektroden in Bezug zur Hülleinrichtung derart angeordnet sind, dass bei Anlage einer elektrischen Potentialdifferenz an den Elektroden ein Plasma im Aufnahmeraum der Hülleinrichtung erzeugbar ist. Eine den Aufnahmeraum der Hülleinrichtung ausbildende Wandung der Hülleinrichtung weist zumindest bereichsweise einen Elastizitätsmodul Ew<10 kN/mm² auf.

Die Vorrichtung umfasst außerdem ein Gehäuse, mit dem ein Gehäuseinnenraum ausgebildet oder ausbildbar ist, wobei die Hülleinrichtung im Gehäuseinnenraum angeordnet ist. Auch dieser Gehäuseinnenraum kann im Wesentlichen gasdicht ausgeführt oder ausführbar sein.

In bevorzugter Ausgestaltung weist das gesamte Material der Hülleinrichtung diesen geringen Elastitzitätsmodul auf, der gewährleistet, dass die Hülleinrichtung mit geringstem Kraftaufwand an eine dreidimensionale Form angepasst werden kann. Dabei soll nicht ausgeschlossen werden, dass das die Wandung der Hülleinrichtung ausbildende Material lediglich bereichsweise diesen verringerten Elastizitätsmodul aufweist, und anschließende Bereiche einen höheren Elastizitätsmodul aufweisen. In dieser Ausgestaltung ist jedoch vorgesehen, dass die Flächenbereiche der Hülleinrichtung, die diesen geringen Elastizitätsmodul von Ew<10 kN/mm² aufweisen, wenigstens 60 % der Fläche der Hülleinrichtung ausmachen.

Vorteilhafterweise sollte bei lediglich bereichsweiser Ausgestaltung der Hülleinrichtung mit diesem geringem Elastizitätsmodul wenigstens 80 % der Fläche der Wandung, vorzugsweise mindestens 90 % der Wandung der Hülleinrichtung, diesen geringen Elastizitätsmodul aufweisen. Insbesondere Versteifungen, Verstrebungen und/oder Verschlusselemente, die an oder in der Hülleinrichtung integriert sind, können einen vergleichsweise höheren Elastizitätsmodul aufweisen. Die Versteifungen bzw. Verstrebungen können aus einem Material ausgeführt sein, welches selbst einen höheren Elastizitätsmodul als 10 kN/mm² aufweist. Dabei sollten sie jedoch vorzugsweise eine Form aufweisen, die ihnen insgesamt eine hohe Elastizität verleiht, wie z. B. einen spiralfeder- oder mäanderförmigen Verlauf.

Das Material der Hülleinrichtung ist vorzugsweise ein Polymer. Die Hülleinrichtung selbst sollte gasdicht ausgestaltet sein.

Die derart zur Verfügung gestellte Hülleinrichtung ist damit zumindest bereichsweise derart flexibel, dass zumindest die Innenseite der Hülleinrichtung der Form des zu behandelnden Gegenstandes komplementär anpassbar ist. Dabei ist es möglich, dass das Material der Hülleinrichtung nicht nur auf Biegung beansprucht wird, sondern gegebenenfalls auch auf Zug, also gestreckt wird. Die Hülleinrichtung kann somit auch vorteilhafterweise in Richtung ihrer Länge, Breite und/oder Höhe verformt werden, dass insgesamt eine Oberflächenvergrößerung oder -verkleinerung stattfindet. Damit ist eine Reduzierung von Totvolumina zwischen der Hülleinrichtung und dem zu behandelnden Gegenstand erreichbar, sodass trotz unterschiedlicher Form und/oder Größe der zu behandelnden Gegenstände von den Elektroden Plasma immer dicht an der Oberfläche des Gegenstandes erzeugt werden kann. Durch die Verringerung der Totvolumina wird zudem nur eine verringerte Menge an Arbeitsgas im Aufnahmeraum benötigt. Des Weiteren sind definierte Druckverhältnisse im Aufnahmeraum sowie dortige Gasführungen einstellbar.

Die erfindungsgemäße Vorrichtung ist vorzugsweise für verschiedene Entladungstypen, wie z. B. für die dielektrisch behinderte Entladung oder auch für Entladungen mit HF- und Mikrowellenanregung geeignet. Unter einer dielektrisch behinderten Entladung (DBE) ist eine Entladung zu verstehen, die zwischen mindestens zwei Elektroden stattfindet, von denen mindestens eine durch ein Dielektrikum isoliert ist. Es wird dabei eine Entladung gezündet, die sich nach sehr kurzer Zeit aufgrund der lokalen Aufladung des Dielektrikums durch den Stromfluss der Entladung in Folge der sich absenkenden Spannung über den Entladungsspalt selbst lokal ausschaltet. Der verwendete Frequenzbereich liegt im Bereich der typischen Netzfrequenz bis zum kHz-Bereich. Hochfrequenz-Entladungen (HF-Entladungen) werden üblicherweise mit einer Gasströmung, einem sogenannten "Jet", gekoppelt und nutzen eine Frequenz im MHz-Bereich. Derartige Entladungen können unter Atmosphärendruck ausgeführt werden. Üblicherweise werden derartige Entladungen in gasdurchströmten Systemen verwendet. Eine Mikrowellenentladung erfolgt typischerweise bei einer Frequenz von 2,45 GHz bzw. 915 MHz oder 9 GHz im Leistungsbereich von einigen W bis mehrere kW.

In bevorzugter Ausgestaltung der erfindungsgemäßen Vorrichtung ist vorgesehen, dass die Hülleinrichtung ein erstes Hüllteil und ein zweites Hüllteil aufweist, wobei das erste Hüllteil und das zweite Hüllteil miteinander gasdicht zur Ausbildung des gasdichten Aufnahmeraums verbindbar sind. Das bedeutet, dass das erste Hüllteil und zweite Hüllteil vorzugsweise achssymmetrisch angeordnete und ausgebildete Elemente der Hülleinrichtung sind, die jeweils für sich eine Konkavität zur Aufnahme eines Bereiches des zu behandelnden Gegenstandes ausbilden. Diese Hüllteile können voneinander entfernt werden, sodass der Aufnahmeraum zur Aufnahme des zu behandelnden Gegenstandes freigegeben wird, der Gegenstand in den Aufnahmeraum platziert werden kann, und die Hüllteile miteinander verbunden werden, sodass die Hülleinrichtung und der Aufnahmeraum geschlossen sind.

Insbesondere für die Ausgestaltungsform, in der die Hülleinrichtung ein erstes und ein zweites Hüllteil aufweist, hat es sich als vorteilhaft herausgestellt, wenn auch das Gehäuse ein erstes Gehäuseteil und ein zweites Gehäuseteil aufweist, wobei das erste Gehäuseteil mit dem zweiten Gehäuseteil derart lösbar verbindbar oder verbunden ist, dass der Gehäuseinnenraum gasdicht ausgeführt ist. Derart kann in einfacher Weise ein Druckgradient über der Hülleinrichtung erzeugt werden, wobei in der Hülleinrichtung bzw. im Aufnahmeraum ein geringerer Druck herrscht als im Gehäuseinnenraum. Dies führt dazu, dass bei Anordnung des Gegenstandes im Aufnahmeraum die Innenseite der Hülleinrichtung sich der Form des Gegenstandes zumindest bereichsweise komplementär anpassen kann. Dabei kann der Druck im Gehäuseinnenraum größer sein als der normale Umgebungsluftdruck.

Bei Ausführung der Hülleinrichtung mit dem ersten und dem zweiten Hüllteil ist vorzugsweise vorgesehen, dass das erste Hüllteil mit dem ersten Gehäuseteil verbunden ist, vorzugsweise gasdicht verbunden ist, und das zweite Hüllteil mit dem zweiten Gehäuseteil verbunden ist, vorzugsweise gasdicht verbunden ist. Durch die gasdichte Verbindung der Gehäuseteile mit den Hüllteilen wird eine gasdichte Ausführung der jeweiligen Gehäuseinnenraumteile realisiert, wobei das jeweilige Gehäuseinnenraumteil nach außen durch das Gehäuseteil begrenzt ist und nach innen durch das jeweilige Hüllteil begrenzt ist. Das bedeutet, dass bei Schließung des Hüllelementes durch die gasdichte Verbindung der Hüllteile auch gleichzeitig das Gehäuse durch die gasdichte Verbindung der Gehäuseraumteile geschlossen wird. Die Erfindung ist jedoch nicht auf diese Ausgestaltung eingeschränkt, sondern sie kann auch derart ausgestaltet sein, dass eine Schließung von Hüllelement und Gehäuse unabhängig voneinander ausgeführt werden kann.

In beiden Varianten ist es jedoch möglich, aufgrund der Teilung der Vorrichtung und der sich dadurch ergebenen zwei Segmente den zu behandelnden Gegenstand in eines der Segmente einzusetzen und dann die beiden Segmente miteinander zu verbinden, sodass der zu behandelnde Gegenstand im Aufnahmeraum der Vorrichtung aufgenommen ist und nach Anpassung der flexiblen Hülleinrichtung an die Form und/oder Größe des Gegenstandes der Gegenstand mit Plasma behandelt werden kann.

Ein Dichtungselement, welches der Abdichtung zwischen einem Hüllteil und einem Gehäuseteil dient, kann gegebenenfalls gleichzeitig auch die Dichtungsfunktion zwischen dem ersten Hüllteil und dem zweiten Hüllteil vornehmen. Das verwendete Dichtungselement ist vorzugsweise derart ausgestaltet, dass durch einen Überdruck außerhalb des Aufnahmeraums in Bezug zum Druck im Aufnahmeraum eine Anpresskraft auf das Dichtungselement erzeugbar ist, sodass das Dichtungselement gasdicht abschließt. Insbesondere kann das Dichtungselement durch eine Dichtungswulst an dem jeweiligen Hüllteil realisiert sein, welche mit einer entsprechend ausgeführten Dichtungswulst am gegenüberliegenden Hüllteil dichtend verbindbar ist.

Neben der elastischen Verformung des Hüllelementes zur Anpassung an die dreidimensionale Form des zu behandelnden Gegenstandes sind jedoch auch plastische Verformungen des Hüllelementes nicht ausgeschlossen, sodass gegebenenfalls auch eine Kombination aus elastischer und plastischer Verformung auftritt. Die Dicke der Wandung des Hüllelementes beträgt vorzugsweise maximal ein Zehntel der maximalen Ausdehnung der unbelasteten Hülleinrichtung.

Die erste und/oder die zweite Elektrode können mittels Befestigungseinrichtungen in Bezug zur Hülleinrichtung und bevorzugt an der Hülleinrichtung befestigt sein, wobei der Abstand zwischen wenigsten einem Paar von zur Befestigung einer Elektrode dienenden benachbarten Befestigungseinrichtungen wenigstens ein Drittel der Länge des Abschnittes dieser Elektrode entspricht, der im Wesentlichen parallel zur äußeren Oberfläche der Hülleinrichtung verläuft. Damit wird gewährleistet, dass das Elektrodenmaterial auf dem Material der Hülleinrichtung mechanisch entkoppelt und elastisch verformbar anliegt, jedoch in nur wenigen Punkten an der Hülleinrichtung befestigt ist. Dies bewirkt, dass zur Verformung der Hülleinrichtung die jeweilige Elektrode zwar im Wesentlichen bei der Bewegung der Hülleinrichtung zur Anpassung an die Form und/ oder Größe des Gegenstandes mitgenommen wird, jedoch nicht zwingend derart starken Formänderungen wie die Hülleinrichtung selbst unterworfen ist. Bei der Verformung der Hülleinrichtung entstehende schwellende oder wechselnde Beanspruchungen werden somit nicht vollständig auf die Elektroden übertragen, sodass diese geringeren Belastungen ausgesetzt sind und eine höhere Lebensdauer aufweisen. Vorzugsweise beträgt der Abstand zwischen wenigstens einem Paar von zur Befestigung einer Elektrode dienenden benachbarten Befestigungseinrichtungen wenigstens die Hälfte der Länge des Abschnittes dieser Elektrode, der im Wesentlichen parallel zur äußeren Oberfläche der Hülleinrichtung verläuft. Dieser parallel verlaufende Abschnitt ist der Bereich der Elektrode, der mit der jeweils anderen Elektrode das Plasma ausbildet, welches den Gegenstand behandelt. Die Parallelität existiert dann, wenn sich die Hülleinrichtung in einem entspannten Ausgangszustand befindet, in dem sie oder auch ihre einzelnen Segmente ein maximales Volumen des Aufnahmeraums ausbilden.

Aufgrund dessen, dass eine oder beide Elektroden relativ locker mit der Hülleinrichtung verbunden sind, werden die Elektroden bei Verformung des Materials der Hülleinrichtung ausreichend weit von dieser bei ihrer Verformung mitgenommen, dass sie dicht genug an dem im Aufnahmeraum angeordneten Gegenstand angeordnet sind, um das zwischen den Elektroden erzeugte Plasma auf den Gegenstand wirken zu lassen. Das Elektrodenmaterial bedeckt vorzugsweise nicht zu 100 % die Oberfläche der Hülleinrichtung, sondern ist strukturiert auf der Oberfläche der Hülleinrichtung angeordnet, wie z. B. in Streifenform.

Eine weitere mögliche Ausführungsform sieht vor, dass die erste Elektrode und/ oder die zweite Elektrode mittels Befestigungseinrichtungen in Bezug zur Hülleinrichtung befestigt ist bzw. sind, wobei im Fall der Befestigung einer Elektrode an der äußeren Seite der Hülleinrichtung, also im Gehäuseinnenraum, die Befestigungseinrichtungen dieser Elektrode am Gehäuse und/ oder an einer durch das Gehäuse führenden strömungstechnischen Verbindung angeordnet sind.

Alternativ oder hinzukommend kann vorgesehen sein, dass im Fall der Befestigung einer Elektrode an der inneren Seite der Hülleinrichtung, also im Aufnahmeraum, die Befestigungseinrichtungen dieser Elektrode durch eine mechanische Verbindung einer mit einer durch das Gehäuse führenden strömungstechnischen Verbindung ausgeführt sind.

Weiterhin ist es möglich, dass die erste Elektrode und/ oder die zweite Elektrode in flüssiger Form ausgeführt ist zwecks optimaler Anpassung an die Form der Hülleinrichtung, so dass bei elastischen Verformungen der Hülleinrichtung bzw. des Dielektrikums immer eine homogene Anpassung an den zu behandelnden Gegenstand möglich ist.

Das bedeutet, dass ein Elektrodenteil dabei in flüssiger Form im Gehäuseinnenraum oder auch im Aufnahmeraum bzw. im Dielektrikum ausgeführt sein kann. Aufgrund der strukturierten Anordnung des Elektrodenmaterials müssen die Elektroden demzufolge nicht eine eventuelle Oberflächengrößenänderungen der Hülleinrichtung ausführen, sondern lediglich Biege- Dehn- oder Schrumpfbewegungen.

Eine Flüssigkeit mit einer bestimmten Leitfähigkeit, wie z.B. Wasser oder Wasser mit einem Zusatz an Salzen, im Gehäuseinnenraum kann direkt als vollwertige, flexible Elektrode genutzt werden. Durch den direkten Kontakt mit dem Dielektrikum werden parasitäre Entladungen vermieden und Ermüdungserscheinungen in der Flüssigelektrode durch Lastwechsel können nicht auftreten. Die Möglichkeiten zur Kühlung bzw. Thermostatisierung sind ebenfalls gegeben.

Vorzugsweise ist die Flüssigkeit dabei in einem oder mehreren Gefäßen, die ebenfalls eine geringe Biegesteifigkeit aufweisen und bevorzugt wenigstens einseitig durch die Hülleinrichtung ausgebildet werden, aufgenommen.

Evtl. auftretende Volumenänderung des mit der Flüssigelektrode gefüllten Gehäuseinnenraums, hervorgerufen durch die Anpassung des flexiblen Dielektrikums an das zu behandelnde Objekt, können über ein Vorratsgefäß, ein Druckausgleichsgefäß oder einen Überlauf realisiert werden.

Die zur Befestigung der Elektroden dienenden Befestigungseinrichtungen können durch eingegossene, verklebte und/oder verwobene Abschnitte realisiert sein. Alternativ ist wenigstens eine Elektrode aufgrund einer elastischen Eigenspannung am Material des Hüllelementes angeordnet, sodass bei Verformung des Hüllelementes die Elektrode aufgrund ihrer elastischen Rückstellkraft dem Hüllelement folgt und sich demzufolge ebenfalls an die Form des zu behandelnden Gegenstandes anpasst.

Zur Befestigung einer Elektrode dienende benachbarte Befestigungseinrichtungen können auch außerhalb des Abschnittes liegen, der parallel zur Wandung der Hülleinrichtung verläuft, wie z. B. Befestigungseinrichtungen, die an den Enden der jeweiligen, damit zu befestigenden Elektrode angeordnet sind. In dieser Ausgestaltung wird demzufolge auch das zur Anpassung der Hülleinrichtung an die Größe und/ oder Form des zu behandelnden Gegenstandes benutzte Druckgefälle dafür verwendet, die Elektrode an die Form und/oder Größe des zu behandelnden Gegenstandes anzupassen. Aufgrund dessen, dass die Elektroden in flexibler Weise der Form bzw. der Größe des zu behandelnden Gegenstandes anpassbar sind, lassen sich geringste Abstände zwischen den Elektroden und dem zu behandelnden Gegenstand realisieren, sodass auch lediglich geringe Spannungen notwendig sind, um das benötigte Plasma zu erzeugen. Entsprechend ist auch ein geringerer Aufwand hinsichtlich der Isolation, des Bauvolumens und der Betriebssicherheit bei verringerter Spannung zu betreiben. Eine Elektrode kann weiterhin durch eine Federkraft, Schwerkraft oder auch Formschluss mit dem Material der Hülleinrichtung verbunden sein und dadurch bei ihrer Bewegung mitgenommen werden. Bei Realisierung eines Formschlusses wird das Material der Hülleinrichtung, welches vorzugsweise auch das Dielektrikum darstellt, mit entsprechenden Rillen, Noppen oder Taschen ausgebildet. Trotzdem ist in bevorzugter Ausgestaltung der erfindungsgemäßen Vorrichtung die erste Elektrode als eine Hochspannungselektrode und die zweite Elektrode als eine geerdete Elektrode auszuführen.

In bevorzugter Ausführungsform sind die erste Elektrode und die zweite Elektrode durch ein Dielektrikum isoliert und dazu eingerichtet, eine dielektrisch behinderte Entladung zur Plasmaerzeugung zu realisieren. Das Dielektrikum ist dabei vorzugsweise das Material bzw. die Wandung der Hülleinrichtung. Insbesondere kann das Hüllmaterial ein elastisches Polymer sein oder ein solches Polymer größtenteils aufweisen. In einer alternativen Ausführungsform ist vorgesehen, dass das für eine dielektrisch behinderte Entladung erforderliche Dielektrikum durch das Behandlungsgut selbst ausgebildet ist. Dabei stellt der zu behandelnde Gegenstand selbst eine eigenständige Elektrode bzw. ein eigenständiges Potential dar. Zusätzlich kann der zu behandelnde Gegenstand über einen Kontakt auch mit einem der Potentiale verbunden werden. Eine im Dielektrikum ausgeführte Elektrode kann in flüssiger Form in Kanälen in diesem Dielektrikum ausgeführt sein. Alternativ oder hinzukommend kann im Gehäuseinnenraum eine flexible Elektrode, z. B. aus Federstahl, genutzt werden. Um eine parasitäre Entladung zu vermeiden, sollte jedoch dann der Gehäuseinnenraum mit einer Substanz gefüllt sein, die eine höhere Durchschlagsfestigkeit für die Entladungsstrecke im Gehäuseinnenraum gewährleistet als ein Arbeitsgas im Aufnahmeraum. Eine solche Substanz können sowohl hochisolierende Flüssigkeiten, wie z. B. Silikon, Öle, als auch Gase, wie z. B. SF6, sein. Mittels Strömung dieses Isolationsmediums lässt sich Wärme aus dem Reaktionsraum abführen bzw. dieser thermostatisieren. Diese Ausgestaltung sollte eine Einrichtung, mit der dieses Medium zur Kühlung der Anlage oder zur Einstellung einer bestimmten Prozesstemperatur umgewälzt werden kann, enthalten.

Zur exakten Positionierung des zu behandelnden Gegenstandes, zur Ausbildung eines Wirkhofes durch das Plasma und zur Verhinderung der negativen Beeinflussung der Zusammensetzung des Arbeitsgases im Aufnahmeraum durch Ausgasungen des Gegenstandes, ist vorgesehen, dass die Hülleinrichtung an ihrer Innenseite, die dem Aufnahmeraum zugewandt ist, zumindest ein Abstandselement aufweist, mit welchem der zu behandelnde Gegenstand beabstandet an der Innenseite der Hülleinrichtung positionierbar ist. Das Aufnahmeelement ist dazu vorgesehen, einen Abstand von z. B. 1 - 3 mm zwischen der Innenseite der Hülleinrichtung und dem Gegenstand einzuhalten, wobei das Abstandselement durch eine Rille, Rippe oder Noppe ausgebildet sein kann. Derartige Rillen, Rippen oder Noppen können tangential an der inneren Oberfläche der Hülleinrichtung verlaufen.

Zusätzlich können an der Innenseite der Hülleinrichtung Gaskanäle bzw. schräge Nuten angeordnet sein, die zwischen der Hülleinrichtung und dem zu behandelnden Gegenstand verlaufen und eine tangentiale Arbeitsgasströmung am Gegenstand erzeugen und/oder den Gegenstand in der Hülleinrichtung zentrieren. Durch eine Erhöhung der Strömungsgeschwindigkeit des Arbeitsgases in diesen Gaskanälen kann ein Abheben des Gegenstandes vom Abstandselement bzw. einer gegebenenfalls stattdessen angeordneten Bodenplatte erreicht werden, sodass auch eine Behandlung des Bodenbereiches des Gegenstandes ermöglicht ist.

Die Vorrichtung kann außerdem derart ausgestaltet sein, dass die Hülleinrichtung im geschlossenen Zustand im Wesentlichen die Form einer Kugel oder eines Ellipsoides aufweist, wobei die Hülleinrichtung mehrere Falten aufweist, die radiale Einkerbungen der Form der Kugel bzw. des Ellipsoides bewirken, wobei die jeweiligen Längserstreckungsrichtungen der Einkerbungen im Wesentlichen parallel zueinander angeordnet sind. Dadurch wird eine Struktur der Hülleinrichtung realisiert, die der einer Zitronenpresse ähnelt. Die Falten können dabei von dem ersten Schnittpunkt einer imaginären Rotationsachse mit der Oberfläche der Hülleinrichtung zum zweiten, gegenüberliegenden Schnittpunkt einer imaginären Rotationsachse mit der Oberfläche der Hülleinrichtung verlaufen. Es bilden sich dabei nicht nur die nach innen gerichteten Falten aus, sondern mit diesen nach innen gerichteten Falten alternierend angeordnet sind auch Falten ausgebildet, die von dem zu behandelnden Gegenstand weg weisen. Auf der Außenseite der Hülleinrichtung verlaufende Elektroden sind dabei vorzugsweise an den Falten positioniert, die dem Behandlungsraum und damit auch dem zu behandelnden Gegenstand zugewandt sind. An der Innenseite der Hülleinrichtung verlaufende Elektroden sind dabei vorzugsweise an oder in den Falten positioniert, die dem Behandlungsraum und damit auch dem zu behandelnden Gegenstand abgewandt sind.

In weiterer vorteilhafter Ausgestaltung der erfindungsgemäßen Vorrichtung weist diese eine Einrichtung zur Erzeugung eines Gasvolumenstroms in den Aufnahmeraum und/oder aus dem Aufnahmeraum auf. Die Vorrichtung ist demzufolge dazu ausgebildet, ein Fluid aus dem Aufnahmeraum abzuziehen und/oder in den Aufnahmeraum strömen zu lassen, wobei das Fluid insbesondere ein Arbeitsgas bzw. ein Arbeitsgasgemisch ist. Das Ziel dieser Einrichtung ist es, das Arbeitsgasgemisch mit leichtem Überdruck in den freien Raum zwischen der Innenseite der Hülleinrichtung und der Oberfläche des zu behandelnden Gegenstandes zu führen, um ein Plasma mit der gewünschten Intensität oder Güte zur Behandlung des Gegenstandes herstellen zu können.

Des Weiteren umfasst die erfindungsgemäße Vorrichtung vorzugsweise eine Einrichtung zur Erzeugung eines Druckgefälles zwischen dem von der Hülleinrichtung ausgebildeten Aufnahmeraum und der Umgebung der Hülleinrichtung. Insbesondere kann dadurch ein Überdruck in einem Gehäuseinnenraum ausgebildet werden, der von der Innenseite des Gehäuses und der Außenseite der Hülleinrichtung ausgebildet ist, sodass in diesem Gehäuseinnenraum ein Druck herstellbar ist, der größer ist als der Druck im Aufnahmeraum, sodass eine Anpassung der leicht verformbaren Hülleinrichtung an die Form und/oder Größe des zu behandelnden Gegenstandes erfolgen kann.

Die Einrichtung zur Erzeugung eines Druckgefälles kann dabei im Wesentlichen dieselben Aggregate aufweisen bzw. durch dieselben Aggregate ausgebildet sein wie die Einrichtung zur Erzeugung eines Gasvolumenstroms.

Das Gehäuse kann eine erste strömungstechnische Verbindung aufweisen, die den Gehäuseinnenraum mit der Umgebung des Gehäuses verbindet und an die insbesondere eine Einrichtung zur Überdruckerzeugung, wie z. B. eine Pumpe angeschlossen ist. Alternativ oder hinzukommend ist vorgesehen, dass die Vorrichtung eine zweite strömungstechnische Verbindung aufweist, die den Aufnahmeraum mit der Umgebung des Gehäuses und insbesondere mit einer Einrichtung zur Unterdruckerzeugung verbindet, wobei auch diese Einrichtung zur Unterdruckerzeugung eine Pumpe sein kann. Derart lässt sich im Gehäuseinnenraum ein Überdruck erzeugen und/oder im Aufnahmeraum ein Unterdruck erzeugen, sodass aufgrund der herrschenden Druckverhältnisse die Hülleinrichtung an den zu behandelnden Gegenstand herangezogen bzw. herangedrückt wird und die in der Nähe der Hülleinrichtung angeordneten Elektroden in der Nähe des Gegenstandes zur Behandlung dessen Plasma erzeugen können. Zur Spülung des Aufnahmeraums, z. B. um sich im Prozess bildende toxische Gase zu entfernen, können die Richtung der Gasströmung sowie gegebenenfalls auch die Druckbereiche umgekehrt werden. Stehende toxische Gase können demzufolge abgesaugt werden, ohne allzu stark verdünnt zu werden. Dies erleichtert die Entsorgung.

Vorzugsweise wird die erfindungsgemäße Vorrichtung mit einer aus einem Fluid realisierten Elektrode in Kombination mit einer durch ein flexibles Dielektrikum isolierten festen, aber flexiblen Elektrode, wie z.B. Federstahl, ausgeführt.

Der Vorteil einer fluiden Elektrode liegt darin, dass dadurch in einfacher Weise eine Kühlung der Elektrode bei Realisierung einer Fluid-Strömung gewährleistet werden kann. Gasströmungen und/oder Arbeitsdruck können über strömungstechnische Verbindungen und entsprechende Einstellungen der Einrichtung zur Erzeugung eines Gasvolumenstroms bzw. der Einrichtung zur Erzeugung eines Druckgefälles eingestellt werden. Die freie Wahl des Arbeitsgasgemisches sowie die Reduzierung des Arbeitsdruckes erlauben es, die dielektrisch behinderte Entladung mit moderaten Spannungen zu betreiben. Aufgrund der Minimierung der Totvolumina ist ebenfalls eine Reduzierung der Pumpleistungen zur Zu- bzw. Abführung der Gase zu verzeichnen. Dies führt neben den geringeren benötigten Gasmengen zu geringeren Kosten hinsichtlich des Evakuierungsprozesses und zur Minimierung der Prozesszeiten. Bei Anwendung der Vorrichtung in Nieder- bis Mitteldruck können mehrere Arbeitsgase eingesetzt werden, wie z. B. Luft, Edelgase oder Formiergase.

Es wird weiterhin erfindungsgemäß ein System zur Behandlung mehrerer Gegenstände mit Plasma zur Verfügung gestellt, welches mehrere erfindungsgemäße Vorrichtungen zur Behandlung eines Gegenstandes mit Plasma umfasst, wobei diese Vorrichtungen derart miteinander mechanisch verbunden sind, dass mit ihnen Bewegungen der jeweiligen ersten und zweiten Hüllteile zwecks Schließung und/oder Öffnung der durch diese Hüllteile zur Verfügung gestellten Aufnahmeräume realisierbar sind. Die Einzelvorrichtungen sind dabei im System zu entsprechenden Mehrfachmodulen oder Paletten kombiniert.

Des Weiteren ist das System vorteilhaft ausgebildet, wenn die ersten Gehäuseteile und die zweiten Gehäuseteile der einzelnen Vorrichtungen zusammen bewegt werden können, sowie wenn eine gemeinschaftliche Einrichtung zur Erzeugung eines Gasvolumenstroms und/oder eine gemeinschaftliche Einrichtung zur Erzeugung eines Druckgefälles vorhanden ist, mit denen die im System eingebundenen Vorrichtungen zusammen mit einem Arbeitsgas befüllt bzw. von diesem Arbeitsgas entlüftet werden können, bzw. mit denen gemeinschaftlich ein Druckgefälle über den Aufnahmeräumen der im System eingebundenen Vorrichtungen erzeugt werden kann. Das erfindungsgemäße System weist den Vorteil der beliebigen Erweiterungsmöglichkeit sowie der erhöhten Prozesssicherheit im Fall des Versagens eines einzelnen Moduls auf.

Ein weiterer Aspekt der erfindungsgemäßen Vorrichtung ist ein Verfahren zur Behandlung eines Gegenstandes mit Plasma mittels einer erfindungsgemäßen Vorrichtung oder auch ein Verfahren zur Behandlung mehrerer Gegenstände mit Plasma mittels des erfindungsgemäßen Systems. Dabei wird ein mit Plasma zu behandelnder Gegenstand in den von der Hülleinrichtung ausgebildeten Aufnahmeraum aufgenommen, der Aufnahmeraum wird im Wesentlichen gasdicht abgeschlossen und die Form und/oder Größe des Aufnahmeraums wird im Wesentlichen der Form und/oder Größe des zu behandelnden Gegenstandes angepasst. Mittels Anlage einer elektrischen Potentialdifferenz an die Elektroden wird ein Plasma im Aufnahmeraum der Hülleinrichtung erzeugt, welches auf den zu behandelnden Gegenstand einwirkt. Vorzugsweise ist der Aufnahmeraum vollständig gasdicht abgeschlossen. Ebenfalls erfolgt vorzugsweise eine vollständige Anpassung der Form und/oder Größe des Aufnahmeraums an die Form und/oder Größe des zu behandelnden Gegenstandes. Vorzugsweise wird dabei eine dielektrisch behinderte Entladung ausgeführt, die mit moderaten Spannungen betrieben wird, wobei eine HFangeregte oder auch eine MW-angeregte Plasmaquelle verwendet werden kann. Die erfindungsgemäße Vorrichtung bzw. das erfindungsgemäße System kann dabei als Grundlage für ein modulares in-line-Verfahren der Plasmabehandlung von Freiformkörpern eingesetzt werden.

In bevorzugter Ausgestaltung des erfindungsgemäßen Verfahrens ist vorgesehen, dass zur Anpassung der Form und/oder Größe des Aufnahmeraums an die Form und/oder Größe des zu behandelnden Gegenstandes ein Druckgefälle über der Hülleinrichtung erzeugt wird, sodass aufgrund der Elastizität der Hülleinrichtung diese sich der Form und/oder Größe des zu behandelnden Gegenstandes zumindest bereichsweise anpasst. D. h., dass mittels Druckgefälle bzw. eines Druckgradienten eine Anpassung der Innenseite der Hülleinrichtung an die Form des zu behandelnden Gegenstandes realisiert wird. Im Gehäuseinnenraum kann dabei z. B. ein Absolutdruck von 200 mbar - 3 000 mbar herrschen. Dabei lässt sich ein Differenzdruck zwischen dem Gehäuseinnenraum und dem Aufnahmeraum von 0 mbar - 2 800 mbar einstellen. Je größer das Druckgefälle zwischen dem Gehäuseinnenraum und dem Aufnahmeraum ist, umso geringere Spannungen sind aufgrund der geometrischen Anpassung der Hülleinrichtung an das Behandlungsgut nötig, um das Plasma zu erzeugen, wie es unter anderem der sogenannten Paschenkurve entnehmbar ist. Sobald aufgrund des Druckgefälles die Hülleinrichtung sich der Form und/oder Größe des zu behandelnden Gegenstandes angepasst hat, erfolgt eine vorzugsweise selbsttätige Dichtfunktion, welche in erster Linie durch die Elastizität des als Material der Hülleinrichtung verwendeten Polymers unterstützt wird.

Ein im Aufnahmeraum benötigtes Arbeitsgas kann davor oder gleichzeitig oder gegebenenfalls danach in den Arbeitsraum, unter Einhaltung der gewünschten Druckverhältnisse, eingebracht werden.

Nach Plasmabehandlung des Gegenstandes wird das verwendete Arbeitsgasgemisch wieder aus dem Arbeitsraum abgezogen. Das Arbeitsgasgemisch kann insbesondere Luft sein oder auch ein Gemisch aus Luft und Argon oder ein Gemisch aus Luft, Argon und Sauerstoff in Verbindung mit NO bzw. NO₂ sowie H₂O.

Bei Realisierung des erfindungsgemäßen Verfahrens mittels des erfindungsgemäßen Systems werden mehrere Gegenstände gleichzeitig mit Plasma behandelt. Diese gleichzeitige Plasmabehandlung erfolgt durch die gleichzeitige Nutzung der erfindungsgemäßen Vorrichtungen.

Insbesondere lässt sich mit dem erfindungsgemäßen Verfahren eine Schalenkeimreduktion von Konsum- und Bruteiern durch atmosphärisches Plasma ermöglichen, wobei ein Druck im Aufnahmeraum eingestellt wird, der dem normalen Atmosphärendruck entspricht.

Ergänzend wird erfindungsgemäß eine Verwendung der erfindungsgemäßen Vorrichtung zur Behandlung eines Gegenstandes mit Plasma zur Verfügung gestellt, wobei die Vorrichtung für die Dekontamination, Desinfektion, Sterilisation, Reinigung, Aktivierung und/oder Beschichtung von Gegenständen, die als Freiformkörper ausgeführt sind, eingesetzt wird. Insbesondere lässt sich die Vorrichtung für die Desinfektion, Sterilisation und/oder Reinigung von Lebensmitteln, wie z. B. von Obst oder Gemüse oder Eiern bzw. von Verpackungen, wie z. B. Flaschen und Boxen, einsetzen. Am Ende des jeweiligen Dekontaminations- bzw. Sterilisations- oder Reinigungsprozesses kann sich eine Sterilverpackung unmittelbar anschließen.

Ein wesentlicher Vorteil der erfindungsgemäßen Vorrichtung liegt darin, dass sich diese bei ihrem Betrieb und der dabei erzeugten Plasmagenerierung selbst desinfiziert und sterilisiert, so dass zwischen einzelnen Behandlungsvorgängen keine extra Säuberungsschritte notwendig sind.

Die Erfindung wir im Folgenden anhand der in den beiliegenden Zeichnungen dargestellten Ausführungsbeispiele erläutert.

Es zeigen
Fig. 1: eine erfindungsgemäße Vorrichtung in geöffneter Darstellung,
Fig. 2: eine erfindungsgemäße Vorrichtung in geschlossener Darstellung,
Fig. 3: eine erfindungsgemäße Vorrichtung in geschlossener Darstellung bei der Behandlung eines Gegenstandes.

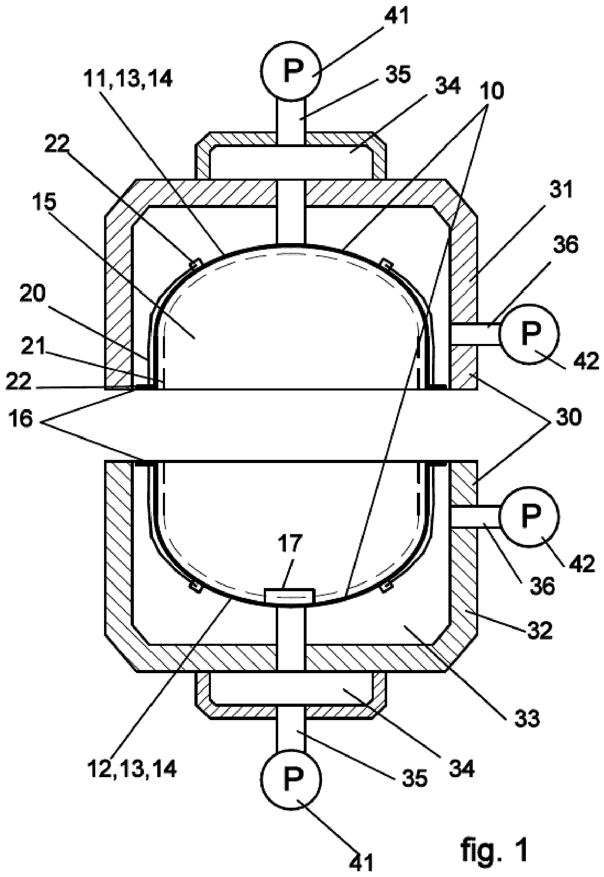

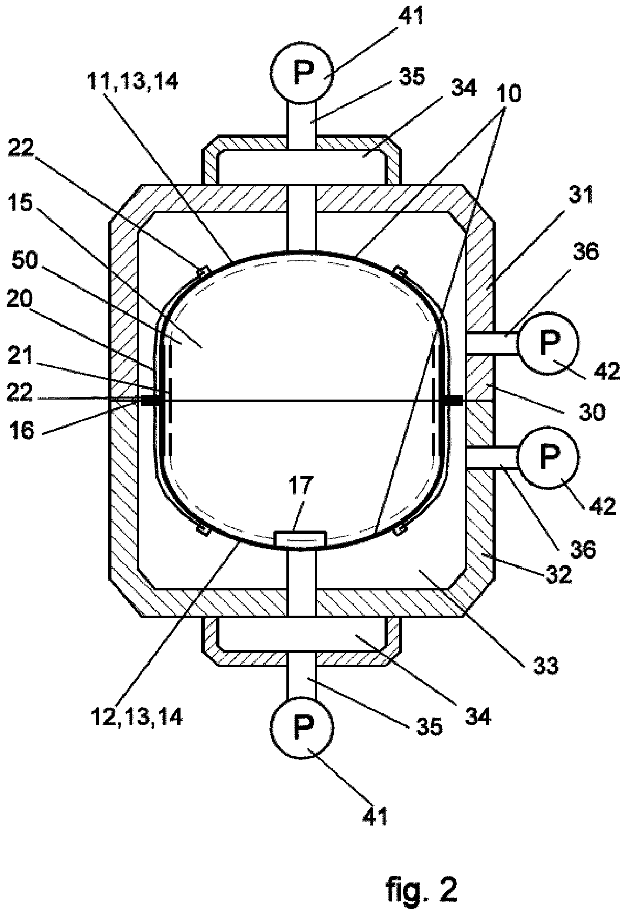

Zunächst wird der Aufbau einer erfindungsgemäßen Vorrichtung anhand der Figuren 1 und 2 erläutert.

Die erfindungsgemäße Vorrichtung umfasst eine Hülleinrichtung 10 die oberes, erstes Hüllteil 11 sowie ein unteres, zweites Hüllteil 12. Die beiden Hüllteile 11, 12 sind als Konkavitäten ausgeführt, sodass sie zwischen sich einen Aufnahmeraum 15 zur Aufnahme eines in den Figuren 1 und 2 noch nicht dargestellten Gegenstandes ausbilden. Die Wandung 13 eines jeweiligen Hüllteils 11, 12 ist relativ dünn ausgeführt und in den vorliegenden Ausführungsbeispielen zumindest bereichsweise aus einem Dielektrikum 14 realisiert. Die beiden Hüllteile 11, 12 lassen sich durch Dichtungselemente 16 miteinander verbinden. An der Außenseite eines jeweiligen Hüllteils 11, 12 ist eine erste Elektrode 20 angeordnet, z. B. als gebogener Metallstreifen, und an der Innenseite ist eine zweite Elektrode 21 angeordnet. Die erste Elektrode 20 ist mittels Befestigungseinrichtungen 22 auf der Oberfläche der Wandung 13 der jeweiligen Hülleinrichtung 11, 12 befestigt. Im unteren Bereich des zweiten Hüllteils 12 befindet sich ein Abstandselement 17 zur Abstützung des aufzunehmenden Gegenstandes.

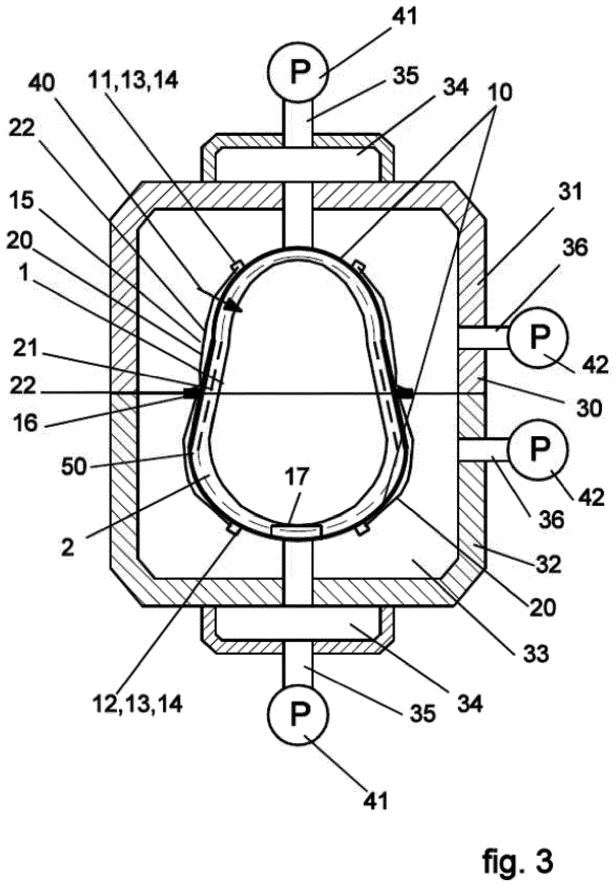

Die Hülleinrichtung 10 ist von einem Gehäuse 30 umgeben, welches durch ein oberes, erstes Gehäuseteil 31 und ein unteres, zweites Gehäuseteil 32 ausgeführt ist. Das erste Gehäuseteil 31 umgibt das erste Hüllteil 11, und das zweite Gehäuseteil 32 umgibt das zweite Hüllteil 12. Durch das Gehäuse 30 wird ein Gehäuseinnenraum 33 zwischen Innenseite der Gehäuseteile 31, 32 und der Außenseite der Hüllteile 11, 12 ausgebildet. An der Außenseite der Gehäuseteile 31, 32 ist jeweils eine Konditionierungskammer 34 angeschlossen. Der Aufnahmeraum 15 ist über eine erste strömungstechnische Verbindung 35 über die Konditionierungskammer 34 mit einer Einrichtung zur Erzeugung eines Gasvolumenstroms 41 strömungstechnisch verbunden. Der Gehäuseinnenraum 33 ist über eine zweite strömungstechnische Verbindung 36 mit einer Einrichtung zur Erzeugung eines Druckgefälles 42 strömungstechnisch verbunden. Mittels der Einrichtung zur Erzeugung eines Gasvolumenstroms 41 ist über die Konditionierungskammer 34 ein Arbeitsgas 50, wie es in Figur 3 dargestellt ist, in den Aufnahmeraum 15 zuführbar bzw. dort nach Plasmabehandlung entstehende toxische Gase aus diesem Arbeitsraum 15 abziehbar. Die Konditionierungskammer 34 dient dabei zur Einstellung der gewünschten Zusammensetzung des Arbeitsgasgemisches bzw. des gewünschten Druckes. Mittels der Einrichtung zur Erzeugung eines Druckgefälles 42, die vorzugsweise als Pumpe ausgeführt ist, lässt sich ein Druck im Gehäuseinnenraum 33 erzeugen, der größer ist als der Druck im Arbeitsraum 15.

In Figur 2 ist die erfindungsgemäße Vorrichtung in geschlossener Darstellung gezeigt, wobei ersichtlich ist, dass das erste Hüllteil 11 und das zweite Hüllteil 12 derart mittels Dichtungselementen verbunden sind, dass der von den Hüllteilen 11, 12 ausgebildete Aufnahmeraum 15 gasdicht abgeschlossen ist. Des Weiteren sind das erste Gehäuseteil 31 und das zweite Gehäuseteil 32 ebenfalls gasdicht miteinander verbunden.

In Figur 3 ist die Arbeitsweise der erfindungsgemäßen Vorrichtung ersichtlich. Durch Erzeugung eines Druckgradienten 40 mittels Einstellung eines Drucks im Gehäuseinnenraum 33, der größer ist als der Druck im Aufnahmeraum 15, erfolgt eine Anpassung der Hülleinrichtung 10 an die Form und/ oder Größe des im Aufnahmeraum 15 aufgenommenen Gegenstandes 1, der hier mit einer Ei-Form dargestellt ist. Die im Inneren der Hülleinrichtung 10 positionierte zweite Elektrode 21 wird dadurch von der Bewegung der Hülleinrichtung 10 mitgenommen und der Oberfläche des zu behandelnden Gegenstandes 1 angepasst. Aufgrund der Befestigung der ersten Elektrode 20 an der äußeren Oberfläche der Hülleinrichtung 10 wird auch diese erste Elektrode 20 bei der Bewegung der Hülleinrichtung 10 von dieser mitgenommen. Die Befestigungseinrichtungen 22 zur Befestigung dieser ersten Elektrode 20 sind derart weit voneinander entfernt, dass die erste Elektrode 20 nicht den selben Formänderungsgrad wie die Hülleinrichtung 10 realisieren muss, jedoch dicht genug weiterhin an der zweiten Elektrode 21 positioniert ist, um ein Plasma durch das jeweilige Hüllteil 11, 12 hindurch erzeugen zu können, um damit den Gegenstand 1 behandeln zu können.

Dieses Plasma 2 wird vorzugsweise durch dielektrisch behinderte Entladung zwischen der ersten Elektrode 20 und der zweiten Elektrode 21 erzeugt, wobei das Material der Hülleinrichtung 10 das Dielektrikum ausbildet. Der zu behandelnde Gegenstand 1 ruht dabei auf dem Abstandselement 17. Durch Einbringung eines entsprechend starken Volumenstroms eines Arbeitsgases 50 mittels der Einrichtung zur Erzeugung eines Gasvolumenstroms 41 lässt sich der zu behandelnde Gegenstand 1 von dem Abstandselement 17 etwas abheben, sodass auch die Zone des Gegenstandes 1, die dem Abstandselement 17 gegenüber liegt, plasmabehandelt werden kann.

Insgesamt ist ersichtlich, dass durch die flexible Anpassung der Hülleinrichtung 10 an die Form und/oder Größe zu behandelnden Gegenstandes 1 das Volumen im Innenraum der Hülleinrichtung, welches mit einem Arbeitsgas zu befüllen ist, stark verringert werden kann, sodass eine entsprechend verringerte Pumpleistung benötigt wird, um den Arbeitsraum mit einem Arbeitsgas 50 zu befüllen bzw. dieses daraus abzuziehen. Zudem erfolgt eine flexible Anpassung der Position der Elektroden an die Position des jeweiligen zu behandelnden Areals des Gegenstandes 1.

Um eine verbesserte Anpassung der Druckverhältnisse im Aufnahmeraum zwischen dem zu behandelnden Gegenstand 1 und der Hülleinrichtung 10 zu erzielen, kann der Abstand dazwischen variiert werden.

Dadurch, dass die Elektroden 20, 21 vorzugsweise nicht über ihre gesamten Längen mit dem Material der Hülleinrichtung 10 verbunden sind, müssen die Elektroden auch nicht den Formänderungsgrad realisieren, den die Hülleinrichtung 10 durchführt, sodass die Elektroden 20, 21 einer geringeren schwellenden oder wechselnden Belastung unterzogen sind und demzufolge eine höhere Lebensdauer der Elektroden und demzufolge auch der gesamten Einrichtung zu erwarten ist.

Die erfindungsgemäße Vorrichtung kann in nahezu beliebiger Weise mit mehreren gleichartigen Vorrichtungen zu einem erfindungsgemäßen System verbunden werden, wobei lediglich die Gehäuseteile 31, 32 der einzelnen Vorrichtungen mechanisch miteinander zu verbinden sind. In bevorzugter Ausführungsform sind auch die Einrichtungen zur Erzeugung eines Gasvolumenstroms 21 bzw. die Einrichtungen zur Erzeugung eines Druckgefälles 42 durch einzelne, den Vorrichtungen gemeinsam zur Verfügung stehende Systeme ausgebildet.

**Bezugszeichenliste**

| | |
|---|---|
| Gegenstand | 1 |
| Plasma | 2 |
| Hülleinrichtung | 10 |
| erstes Hüllteil | 11 |
| zweites Hüllteil | 12 |
| Wandung | 13 |
| Dielektrikum | 14 |
| Aufnahmeraum | 15 |
| Dichtungselement(Dichtungswulst) | 16 |
| Abstandselement | 17 |
| erste Elektrode | 20 |
| zweite Elektrode | 21 |
| Befestigungseinrichtung | 22 |
| Gehäuse | 30 |
| erstes Gehäuseteil | 31 |
| zweites Gehäuseteil | 32 |
| Gehäuseinnenraum | 33 |
| Konditionierungskammer | 34 |
| erste strömungstechnische Verbindung | 35 |
| zweite strömungstechnische Verbindung | 36 |
| Druckgradient | 40 |
| Einrichtung zur Erzeugung eines Gasvolumenstromes | 41 |
| Einrichtung zur Erzeugung eines Druckgefälles | 42 |

## Patentansprüche

1. Vorrichtung zur Behandlung eines Gegenstandes (1) mit Plasma (2), umfassend eine Hülleinrichtung (10), mit der ein im Wesentlichen gasdichter Aufnahmeraum (15) ausgebildet ist oder ausbildbar ist, in dem ein zu behandelnder Gegenstand (1) aufnehmbar ist, und eine erste Elektrode (20) sowie eine zweite Elektrode (21), wobei die beiden Elektroden (20, 21) in Bezug zur Hülleinrichtung (10) derart angeordnet sind, dass bei Anlage einer elektrischen Potenzialdifferenz an den Elektroden (20, 21) ein Plasma (2) im Aufnahmeraum (15) der Hülleinrichtung (10) erzeugbar ist,
wobei eine den Aufnahmeraum (15) der Hülleinrichtung (10) ausbildende Wandung (13) der Hülleinrichtung (10) zumindest bereichsweise einen Elastizitätsmodul Ew <10 kN/mm² aufweist, **dadurch gekennzeichnet,**
**dass** die Vorrichtung ein Gehäuse (30) aufweist, mit dem ein Gehäuseinnenraum (33) ausgebildet oder ausbildbar ist, wobei die Hülleinrichtung (10) im Gehäuseinnenraum (33) angeordnet ist.

2. Vorrichtung zur Behandlung eines Gegenstandes mit Plasma nach Anspruch 1, dass die Hülleinrichtung (10) ein erstes Hüllteil (11) und ein zweites Hüllteil (12) aufweist, wobei das erste Hüllteil (11) und das zweite Hüllteil (12) miteinander gasdicht zur Ausbildung des gasdichten Aufnahmeraums (15) verbindbar sind.

3. Vorrichtung zur Behandlung eines Gegenstandes mit Plasma nach einem der vorhergehenden Ansprüche, **dadurch gekennzeichnet, dass** das Gehäuse (30) ein erstes Gehäuseteil (31) und ein zweites Gehäuseteil (32) aufweist, wobei das erste Gehäuseteil (31) mit dem zweiten Gehäuseteil (32) derart lösbar verbindbar oder verbunden ist, dass der Gehäuseinnenraum (33) gasdicht ausgeführt ist.

4. Vorrichtung zur Behandlung eines Gegenstandes mit Plasma nach einem der vorhergehenden Ansprüche, dass die erste Elektrode (20) und/ oder die zweite Elektrode (21) mittels Befestigungseinrichtungen (22) in Bezug zur Hülleinrichtung (10) befestigt ist bzw. sind, wobei im Fall der Befestigung einer Elektrode an der äußeren Seite der Hülleinrichtung (10) die Befestigungseinrichtungen (22) dieser Elektrode am Gehäuse (30) und/ oder an einer durch das Gehäuse (30) führenden strömungstechnischen Verbindung (35) angeordnet sind,
und/oder
im Fall der Befestigung einer Elektrode an der inneren Seite der Hülleinrichtung (10) die Befestigungseinrichtungen (22) dieser Elektrode durch eine mechanische Verbindung einer mit einer durch das Gehäuse (30) führenden strömungstechnischen Verbindung (35) ausgeführt sind.

5. Vorrichtung zur Behandlung eines Gegenstandes mit Plasma nach einem der Ansprüche 1 bis 3, dass die erste Elektrode (20) und/ oder die zweite Elektrode (21) in flüssiger Form ausgeführt ist.

6. Vorrichtung zur Behandlung eines Gegenstandes mit Plasma nach einem der vorhergehenden Ansprüche, **dadurch gekennzeichnet, dass** die erste Elektrode (20) und die zweite Elektrode (21) durch ein Dielektrikum (14) isoliert sind, und dazu eingerichtet sind, eine dielektrisch behinderte Entladung zur Plasmaerzeugung zu realisieren.

7. Vorrichtung zur Behandlung eines Gegenstandes mit Plasma nach einem der vorhergehenden Ansprüche, dass die Hülleinrichtung (10) im geschlossenen Zustand im Wesentlichen die Form einer Kugel oder eines Ellipsoides aufweist, wobei die Hülleinrichtung mehrere Falten aufweist, die radiale Einkerbungen der Form der Kugel bzw. des Ellipsoides bewirken, wobei die jeweiligen Längserstreckungsrichtungen der Einkerbungen im Wesentlichen parallel zueinander angeordnet sind.

8. Vorrichtung zur Behandlung eines Gegenstandes mit Plasma nach einem der vorhergehenden Ansprüche, **dadurch gekennzeichnet, dass** die Vorrichtung eine Einrichtung zur Erzeugung eines Gasvolumenstromes (41) in den Aufnahmeraum (15) und/ oder aus dem Aufnahmeraum (15) aufweist.

9. Vorrichtung zur Behandlung eines Gegenstandes mit Plasma nach einem der vorhergehenden Ansprüche, **dadurch gekennzeichnet, dass** die Vorrichtung eine Einrichtung zur Erzeugung eines Druckgefälles (42) zwischen dem von der Hülleinrichtung (10) ausgebildeten Aufnahmeraum (15) und der Umgebung der Hülleinrichtung (10) aufweist.

10. System zur Behandlung mehrerer Gegenstände mit Plasma, umfassend mehrere Vorrichtungen zur Behandlung eines Gegenstandes mit Plasma gemäß einem der Ansprüche 2 bis 9, wobei diese Vorrichtungen derart miteinander mechanisch verbunden sind, dass mit ihnen Bewegungen der jeweiligen ersten Hüllteile (11) und zweiten Hüllteile 12 zwecks Schließung und/ oder Öffnung der durch diese Hüllteile (11, 12) zur Verfügung gestellten Aufnahmeräume (15) realisierbar sind.

11. Verfahren zur Behandlung eines Gegenstandes mit Plasma mittels einer Vorrichtung gemäß einem der Ansprüche 1 bis 9 oder mittels eines Systems gemäß Anspruch 10, bei dem ein mit Plasma (2) zu behandelnder Gegenstand (1) in den von der Hülleinrichtung (15) ausgebildeten Aufnahmeraum (15) aufgenommen wird, der Aufnahmeraum (15) im Wesentlichen gasdicht abgeschlossen wird, die Form und/ oder Größe des Aufnahmeraums (15) zumindest bereichsweise der Form und/ oder Größe des zu behandelnden Gegenstandes (1) angepasst wird, und mittels Anlage einer elektrischen Potenzialdifferenz an die Elektroden (20, 21) ein Plasma (2) im Aufnahmeraum (15) der Hülleinrichtung (10) erzeugt wird, welches auf den zu behandelnden Gegenstand (1) einwirkt.

12. Verfahren zur Behandlung eines Gegenstandes mit Plasma nach Anspruch 11, dass zur Anpassung der Form und/ oder Größe des Aufnahmeraums (15) an die Form und/ oder Größe des zu behandelnden Gegenstandes (1) ein Druckgefälle über der Hülleinrichtung (10) erzeugt wird, so dass auf Grund der Elastizität der Hülleinrichtung (10) diese sich der Form und/ oder Größe des zu behandelnden Gegenstandes (1) zumindest bereichsweise anpasst.

13. Verfahren zur Behandlung eines Gegenstandes mit Plasma nach einem der Ansprüche 11 und 12, dass in den Aufnahmeraum (15) vor oder gleichzeitig mit der Plasmaerzeugung ein Arbeitsgas (50) eingeleitet wird.

14. Verfahren zur Behandlung eines Gegenstandes mit Plasma nach einem der Ansprüche 11 bis 13, dass das Verfahren mittels eines Systems gemäß Anspruch 10 ausgeführt wird, wobei mehrere Gegenstände (1) gleichzeitig mit Plasma (2) behandelt werden.

## Claims

1. A device for treating an object (1) with plasma (2), comprising a jacket apparatus (10) which forms, or can form, a substantially gas-tight holding chamber (15) in which an object (1) to be treated can be accommodated, and a first electrode (20) as well as a second electrode (21), wherein the two electrodes (20, 21) are arranged with reference to the jacket apparatus (10) such that, when an electric difference in potential is applied to the electrodes (20, 21), a plasma (2) can be generated in the holding chamber (15) of the jacket apparatus (10), wherein a wall (13) of the jacket apparatus (10) forming the holding chamber (15) of the jacket apparatus (10) has a modulus of elasticity of Ew<10 kN/mm², at least in sections, **characterized in that** the device comprises a housing (30), by means of which a housing interior (33) is or can be formed, wherein the jacket apparatus (10) is arranged within the interior of the housing (33).

2. The device for treating an object with plasma according to claim 1, **characterized in that** the jacket apparatus (10) has a first jacket part (11) and a second jacket part (12), wherein the first jacket part (11) and the second jacket part (12) are connectable to each other gas-tight to form the gas-tight holding chamber (15).

3. The device for treating an object with plasma according to any of the preceding claims, **characterized in that** the housing (30) has a first housing part (31) and a second housing part (33), wherein the first housing part (31) is releasably connectable or connected to the second housing part (32) such that the housing interior (33) is designed gas-tight.

4. The device for treating an object with plasma according to any of the preceding claims, **characterized in that** the first electrode (20) and/or the second electrode (21) is/are fastened with respect to the jacket apparatus (15) by means of fastening means (22), wherein when an electrode is fastened to the outer side of the jacket apparatus (10), the fastening means (22) of this electrode are arranged on the housing (30) and/or on a fluidic connection (35) running through the housing (30).
and/or
when an electrode is fastened to the inner side of the jacket apparatus (10), the fastening means (22) for this electrode are designed with a mechanical connection of a fluidic connection (35) running through the housing (30).

5. The device for treating an object with plasma according to one of the claims 1 to 3, **characterized in that** the first electrode (20) and/or the second electrode (21) is designed in liquid form.

6. The device for treating an object with plasma according to one of the preceding claims, **characterized in that** the first electrode (20) and second electrode (21) are insulated by a dielectric (14) and configured to realize a dielectric barrier discharge to generate plasma.

7. The device for treating an object with plasma according to one of the preceding claims, **characterized in that** the jacket apparatus (10), in a closed state, basically has the shape of a sphere or ellipsoid, wherein the jacket apparatus has a plurality of folds that create radial notches in the shape of the sphere, or respectively ellipsoid, wherein the respective directions of longitudinal extension of the notches are arranged substantially parallel to each other.

8. The device for treating an object with plasma according to one of the preceding claims, **characterized in that** the device has an apparatus for generating a volumetric flow of gas (41) into the holding chamber (15) and/or out of the holding chamber (15).

9. The device for treating an object with plasma according to one of the preceding claims, **characterized in that** the device has an apparatus for generating a pressure gradient (42) between the holding chamber (15) forming the jacket apparatus (10) and the surroundings of the jacket apparatus (10).

10. A system for treating a plurality of objects with plasma, comprising a plurality of devices for treating at an object with plasma according to one of the claims 2 to 9, wherein these devices are mechanically connected to each other such that movements of the respective first jacket part (11) and the second jacket part (12) can be performed by them to close and/or open the holding chambers (15) provided by these jacket parts (11, 12).

11. A method for treating an object with plasma by means of a device according to one of claims 1 to 9, or by means of a system according to claim 10, wherein an object (1) to be treated with plasma (2) is accommodated in the holding chamber (15) formed by the jacket apparatus (15), the holding chamber (15) is sealed substantially gas-tight, the shape and/or size of the holding chamber (15) is at least in sections adapted to the shape and/or size of the object (1) to be treated, and by applying an electrical difference in potential to the electrodes (20, 21), a plasma (2) is generated in the holding chamber (15) of the jacket apparatus (10) that acts on the object (1) to be treated.

12. The method for treating an object with plasma according to claim 11, **characterized in that** a pressure gradient is generated over the jacket apparatus (10) to adapt the shape and/or size of the holding chamber (15) to the shape and/or size of the object (1) to be treated so that, given the elasticity of the jacket device (10), it adapts at least sectionally to the shape and/or size of the object (1) to be treated.

13. The method for treating an object with plasma according to one of claims 11 and 12, **characterized in that** a process gas (50) is introduced into the holding chamber (15) before or at the same time as the plasma generation takes place.

14. The method for treating an object with plasma according to one of claims 11 to 13, in that the method is performed by means of a system according to claim 10, wherein a plurality of objects (1) is treated simultaneously with plasma (2).

## Revendications

1. Dispositif de traitement d'un objet (1) au plasma (2), comprenant un moyen d'enveloppement (10), avec lequel un espace de réception (15) sensiblement étanche aux gaz est formé ou peut être formé, à l'intérieur duquel un objet à traiter (1) peut être logé, et une première électrode (20) ainsi qu'une seconde électrode (21), dans lequel les deux électrodes (20, 21) sont disposées par rapport au moyen d'enveloppement (10), de telle manière qu'un plasma (2) peut être généré dans l'espace de réception (15) du moyen d'enveloppement (10) lors de l'application d'une différence de potentiel électrique entre les électrodes (20, 21),
dans lequel une paroi (13) du moyen d'enveloppement (10) formant l'espace de réception (15) du moyen d'enveloppement (10) présente au moins par endroits un module d'élasticité Ew <10 kN/mm², **caractérisé en ce que**
le dispositif présente un boîtier (30), avec lequel un espace intérieur de boîtier (33) est formé ou peut être formé, sachant que le moyen d'enveloppement (10) est disposé dans l'espace intérieur de boîtier (33).

2. Dispositif de traitement d'un objet au plasma selon la revendication 1, **caractérisé en ce que** le moyen d'enveloppement (10) présente une première partie d'enveloppe (11) et une seconde partie d'enveloppe (12), dans lequel la première partie d'enveloppe (11) et la seconde partie d'enveloppe (12) peuvent être reliées l'une à l'autre de façon étanche aux gaz pour former l'espace de réception (15) étanche aux gaz.

3. Dispositif de traitement d'un objet au plasma selon l'une quelconque des revendications précédentes, **caractérisé en ce que** le boîtier (30) présente une première partie de boîtier (31) et une seconde partie de boîtier (32), dans lequel la première partie de boîtier (31) peut être reliée ou est reliée à la seconde partie de boîtier (32) de façon amovible, de telle manière que l'espace intérieur de boîtier (33) est réalisé de façon étanche aux gaz.

4. Dispositif de traitement d'un objet au plasma selon l'une quelconque des revendications précédentes, **caractérisé en ce que** la première électrode (20) et / ou la seconde électrode (21) est fixée ou sont fixées à l'aide de moyens de fixation (22) par rapport au moyen d'enveloppement (10), sachant qu'en cas de fixation d'une électrode sur la face extérieure du moyen d'enveloppement (10), les moyens de fixation (22) de cette électrode sont disposés sur le boîtier (30) et / ou sur une connexion fluidique (35) traversant le boîtier (30),
et / ou
qu'en cas de fixation d'une électrode sur la face intérieure du moyen d'enveloppement (10), les moyens de fixation (22) de cette électrode sont réalisés par un raccordement mécanique avec une connexion fluidique (35) traversant le boîtier (30).

5. Dispositif de traitement d'un objet au plasma selon l'une quelconque des revendications 1 à 3, **caractérisé en ce que** la première électrode (20) et / ou la seconde électrode (21) sont réalisées sous forme liquide.

6. Dispositif de traitement d'un objet au plasma selon l'une quelconque des revendications précédentes, **caractérisé en ce que** la première électrode (20) et la seconde électrode (21) sont isolées par un diélectrique (14) et qu'elles sont ajustées pour créer une décharge à barrière diélectrique afin de générer le plasma.

7. Dispositif de traitement d'un objet au plasma selon l'une quelconque des revendications précédentes, **caractérisé en ce que** le moyen d'enveloppement (10) présente à l'état fermé sensiblement la forme d'une sphère ou d'un ellipsoïde, dans lequel le moyen d'enveloppement présente plusieurs plis, qui induisent des indentations radiales dans la forme de la sphère ou de l'ellipsoïde, dans lequel les directions respectives d'extension longitudinale des indentations sont disposées sensiblement en parallèle les unes des autres.

8. Dispositif de traitement d'un objet au plasma selon l'une quelconque des revendications précédentes, **caractérisé en ce que** le dispositif présente un moyen servant à générer un débit volumique de gaz (41) s'écoulant dans l'espace de réception (15) et / ou hors de l'espace de réception (15).

9. Dispositif de traitement d'un objet au plasma selon l'une quelconque des revendications précédentes, **caractérisé en ce que** le dispositif présente un moyen servant à générer un gradient de pression (42) entre l'espace de réception (15) formé par le moyen d'enveloppement (10) et l'environnement du moyen d'enveloppement (10).

10. Système destiné à traiter plusieurs objets au plasma, comprenant plusieurs dispositifs de traitement d'un objet au plasma selon l'une quelconque des revendications 2 à 9, dans lequel ces dispositifs sont reliés mécaniquement les uns aux autres, de telle manière qu'ils permettent de mouvoir respectivement la première partie d'enveloppe (11) et la seconde partie d'enveloppe (12) dans le but de fermer et / ou d'ouvrir les espaces de réception (15) mis à disposition par ces parties d'enveloppe (11, 12).

11. Procédé de traitement d'un objet au plasma à l'aide d'un dispositif selon l'une quelconque des revendications 1 à 9 ou à l'aide d'un système selon la revendication 10, au cours duquel un objet (1) à traiter avec du plasma (2) est logé dans l'espace de réception (15) formé par le moyen d'enveloppement (15), l'espace de réception (15) est fermé de façon sensiblement étanche aux gaz, la forme et / ou la taille de l'espace de réception (15) épouse au moins par endroits la forme et / ou la taille de l'objet à traiter (1), et l'application d'une différence de potentiel électrique entre les électrodes (20, 21) permet de générer un plasma (2) dans l'espace de réception (15) du moyen d'enveloppement (10), lequel agit sur l'objet à traiter (1).

12. Procédé de traitement d'un objet au plasma selon la revendication 11, **caractérisé en ce qu'**un gradient de pression est généré au-dessus du moyen d'enveloppement (10) afin d'adapter la forme et / ou la taille de l'espace de réception (15) à la forme et / ou à la taille de l'objet à traiter (1), de sorte que le moyen d'enveloppement (10) épouse de par son élasticité au moins par endroits la forme et / ou la taille de l'objet à traiter (1).

13. Procédé de traitement d'un objet au plasma selon l'une des revendications 11 et 12, **caractérisé en ce qu'**un gaz de travail (50) est introduit dans l'espace de réception (15) avant ou en même temps que la production de plasma.

14. Procédé de traitement d'un objet au plasma selon l'une quelconque des revendications 11 à 13, **caractérisé en ce que** le procédé est exécuté à l'aide d'un système selon la revendication 10, dans lequel plusieurs objets (1) sont traités en même temps avec du plasma (2).
